# EUROPEAN PATENT APPLICATION

(11) **EP 4 614 172 A1**
(43) Date of publication of application: **10.09.2025**
(21) Application number: 24803613.9
(22) Date of filing: 17.04.2024
(51) Int. Cl.: G01R 31/396, G01R 31/367, G01R 31/371, G01R 31/382, H02J 7/00, B60R 16/033

(54) **MANAGEMENT METHOD FOR BATTERY DATA AND BATTERY MANAGEMENT SYSTEM PROVIDING SAME**

(30) Priority: 10.05.2023 KR 20230060584
(71) Applicant: LG Energy Solution, Ltd., Seoul 07335 (KR)
(72) Inventor: SUN, Ju Young, Daejeon 34122 (KR); LEE, Heonguk, Daejeon 34122 (KR); KANG, Hoseok, Daejeon 34122 (KR)
(74) Representative: BCKIP Part mbB
(86) International application number: PCT/KR2024/005171
(87) International publication number: WO 2024/232558

(57) **Abstract**

The present disclosure relates to a battery data management method and a battery management system (BMS) providing the method, and the BMS includes a plurality of slave BMSs each configured to collect and store battery data including state information of a battery module for each predetermined storage period, and a master BMS configured to receive the battery data and identification data including identification information of each of the plurality of slave BMSs from each of the plurality of slave BMSs for each storage period, and map and store the battery data and the identification data.

## Description

### [Technical Field]

### CROSS-REFERENCE TO RELATED APPLICATION

This application claims priority to and the benefit of Korean Patent Application No. 10-2023-0060584 filed in the Korean Intellectual Property Office on May 10, 2023, the entire contents of which are incorporated herein by reference.

The present disclosure relates to a battery data management method and a battery management system providing the method.

### [Background Art]

Since batteries used in vehicles, etc. are also products, battery manufacturers or sellers provide after-service (A/S) for batteries sold during a warranty period. A/S is a service that provides services such as repair, installation, inspection, etc. of sold products to consumers at a special price, etc.

Sellers provide A/S based on warranty data such as a cumulative count of charge/discharge cycles of batteries, cumulative discharge energy, etc. For example, sellers may set the warranty period until the cumulative count of charge/discharge cycles reaches 1000 times.

The warranty data is battery data that is the basis for determining for application of A/S, and may be collected and/or calculated by a slave battery management system (BMS) electrically connected to batteries. For example, when a battery system includes a plurality of battery modules, a plurality of warranty data respectively corresponding to the plurality of battery modules may be collected and/or calculated by a plurality of slave BMSs electrically connected to the plurality of battery modules, respectively. The collected warranty data may be stored in a storage unit of the slave BMS.

Meanwhile, when a defect occurs in a battery module or when the lifespan of the battery module ends, a battery pack including the battery module and the slave BMS may be replaced with a new battery pack. Alternatively, only a master BMS that controls a plurality of slave BMSs may be newly replaced. In this case, it is necessary to update warranty data reflecting the current state.

In the related art, updating warranty data by transferring the warranty data to the master BMS involved cumbersome tasks such as connecting PC communication cables and executing programs for data transfer.

### [Disclosure]

### [Technical Problem]

The present disclosure attempts to provide a battery data management method capable of efficiently storing and managing battery data, and a battery management system providing the method.

### [Technical Solution]

According to an aspect of the present disclosure, a battery management system (BMS) includes a plurality of slave BMSs each configured to collect and store battery data including state information of a battery module for each predetermined storage period, and a master BMS configured to receive the battery data and identification data including identification information of each of the plurality of slave BMSs from each of the plurality of slave BMSs for each storage period, and map and store the battery data and the identification data.

The battery data may include information of at least one of a total number of charge/discharge cycles of the battery module and total energy discharged from the battery module.

The master BMS may transmit the stored battery data to an external system when receiving a request signal of the battery data from the external system.

The master BMS may request and receive the identification data from each of the plurality of slave BMSs when receiving a transmission request signal of the battery data, and transmit the stored battery data to the external system when the received identification data matches the stored identification data.

The master BMS may request and receive the battery data from a slave BMS corresponding to identification data that does not match when the received identification data does not match the stored identification data, and update the stored battery data to the received battery data.

The master BMS may transmit the battery data stored in the master BMS to the external system after an update.

The master BMS may request and receive the identification data from each of the plurality of slave BMSs when receiving power from a power source and waking up, request and receive the battery data from at least one slave BMS in which the received identification data does not match previously stored identification data, and update the stored battery data to the received battery data.

According to another aspect of the present disclosure, a battery data management method, performed by a master BMS, of managing battery data collected by each of a plurality of slave BMSs electrically connected to a plurality of battery modules for each predetermined storage period and stored in each of the plurality of slave BMSs includes receiving a request signal of the battery data including state information of each of the plurality of battery modules from an external system, and transmitting, to the external system, the battery data that is received from each of the plurality of slave BMSs for each storage period, mapped to identification data including identification information of each of the plurality of slave BMSs, and stored.

The battery data may include information of at least one of a total number of charge/discharge cycles of each of the plurality of battery modules and total energy discharged from each of the plurality of battery modules.

The battery data management method may further include, after the receiving of the request signal of the battery data, requesting and receiving the identification data from each of the plurality of slave BMSs, and determining whether the received identification data matches identification data stored in the master BMS, and the transmitting, to the external system, may include transmitting the battery data stored in the master BMS to the external system when it is determined that the received identification data matches the identification data.

The battery data management method may further include, after the determining of whether the received identification data matches the previously stored identification data, requesting and receiving the battery data from at least one slave BMS corresponding to identification data that does not match when it is determined that the received identification data does not match the identification data, and updating the stored battery data to the received battery data, and the transmitting, to the external system, may include transmitting the battery data stored in the master BMS to the external system after the updating.

According to another aspect of the present disclosure, a battery data management method, performed by a master BMS, of managing battery data collected by each of a plurality of slave BMSs electrically connected to a plurality of battery modules for each predetermined storage period and stored in each of the plurality of slave BMSs includes receiving power from a power source and waking up, requesting and receiving identification data including identification information of each of the plurality of slave BMSs to each of the plurality of slave BMSs, determining whether the received identification data matches identification data stored in the master BMS, requesting and receiving the battery data from at least one slave BMS corresponding to identification data that does not match when it is determined that the received identification data does not match the identification data, and updating the battery data stored in the master BMS to the received battery data.

The battery data may be mapped to the identification data and stored in the master BMS.

The battery data may include information of at least one of a total number of charge/discharge cycles of each of the plurality of battery modules and total energy discharged from each of the plurality of battery modules.

### [Advantageous Effects]

In the present disclosure, when a slave BMS or a master BMS is replaced, warranty data may be updated to the latest state without connecting a PC communication cable and executing a program for battery data transfer.

### [Description of the Drawings]

FIG. 1 is a diagram illustrating a battery system according to an embodiment.
FIG. 2 is a block diagram illustrating a configuration of a slave battery management system (BMS) of FIG. 1.
FIG. 3 is a block diagram illustrating a configuration of a master BMS of FIG. 1.
FIG. 4 is a conceptual view illustrating a state in which battery data is stored in a plurality of slave BMSs and a master BMS according to an embodiment.
FIG. 5 is a conceptual view illustrating a method of updating battery data when a master BMS is replaced according to an embodiment.
FIG. 6 is a conceptual view for explaining a method of updating battery data when a first slave BMS is replaced according to an embodiment.
FIG. 7 is a flowchart illustrating a method of storing battery data collected by a slave BMS in a master BMS according to another embodiment.
FIG. 8 is a flowchart illustrating a method of updating battery data stored in a master BMS according to another embodiment.
FIG. 9 is a flowchart illustrating a method, performed by a master BMS, of transmitting battery data to an external system according to another embodiment.

### [Mode for Invention]

Hereinafter, the embodiments disclosed in the present specification will be described in detail with reference to the accompanying drawings, but same or similar components are given the same or similar reference numerals, and redundant descriptions thereof will be omitted. The suffixes "module" and/or "part" for components used in the following description are given or mixed in consideration of only the ease of drafting the specification, and do not have meanings or roles distinct from each other by themselves. In addition, in describing the embodiments disclosed in the present specification, when it is determined that detailed descriptions of related known technologies may obscure the gist of the embodiments disclosed in the present specification, the detailed description thereof will be omitted. In addition, the accompanying drawings are only for easy understanding of the embodiments disclosed in the present specification, do not limit the technical idea disclosed in the present specification, and should be understood to include all changes, equivalents or substitutes included in the spirit and scope of the present disclosure.

The terms including an ordinal number, such as first, second, etc., may be used to describe various components, but the components are not limited by the terms. The terms are used only for the purpose of distinguishing one component from another.

It will be understood that when a component is referred to as being "connected to" or "coupled to" another component, the component may be connected or coupled to the other component or intervening components may be present. In contrast, when a component is referred to as being "directly connected to" or "directly coupled to" another component, there are no intervening components present.

It will be further understood that the terms "comprises" and/or "comprising," when used in the present specification, specify the presence of stated features, integers, steps, operations, components, and/or parts, but do not preclude the presence or addition of one or more other features, integers, steps, operations, components, parts, and/or combinations thereof.

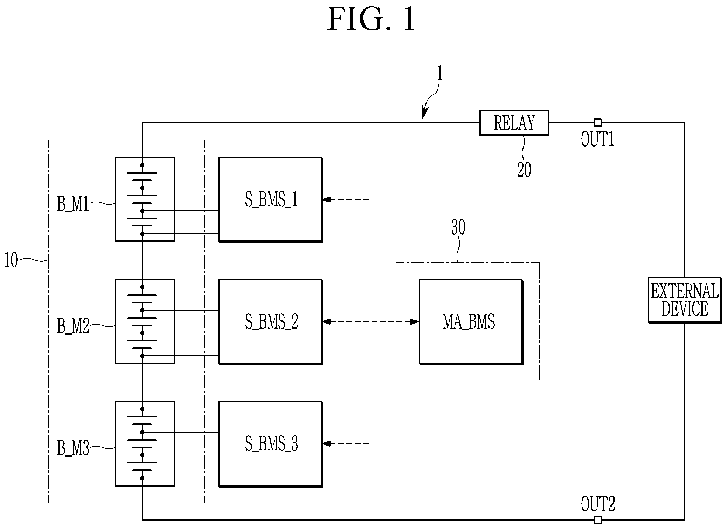

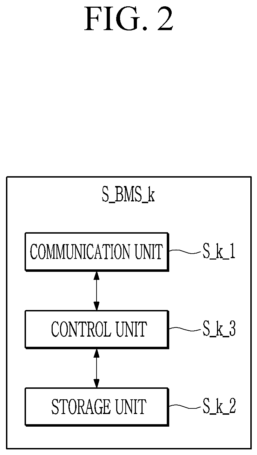

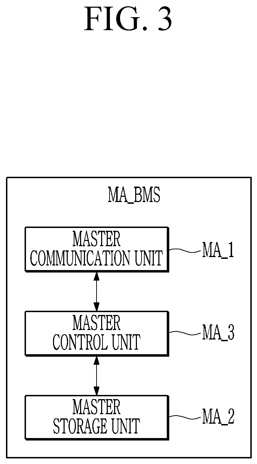

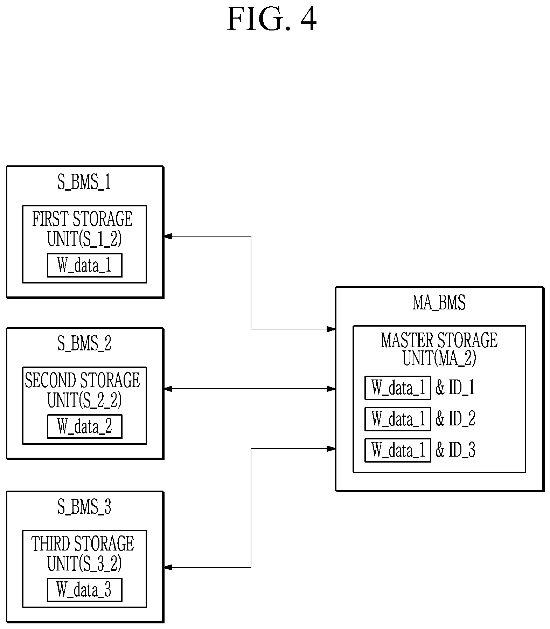

FIG. 1 is a diagram illustrating a battery system according to an embodiment. FIG. 2 is a block diagram illustrating a configuration of a slave battery management system (BMS) of FIG. 1. FIG. 3 is a block diagram illustrating a configuration of a master BMS of FIG. 1. FIG. 4 is a conceptual view illustrating a state in which battery data is stored in a plurality of slave BMSs and the master BMS according to an embodiment.

Referring to FIG. 1, a battery system 1 includes a battery 10, a relay 20, and a BMS 30.

The battery 10 may include a plurality of battery modules B_M including a plurality of battery cells electrically connected in series and in parallel. In an embodiment, the battery cell may be a rechargeable secondary battery. FIG. 1 shows the battery 10 including three battery modules B_M including three battery cells connected in series, but the present disclosure is not limited thereto. The battery 10 may include the plurality of battery modules B_M including various numbers of battery cells connected in series and in parallel. Each of the plurality of battery cells may be electrically connected to a slave BMS (hereinafter, referred to as 'S_BMS') through wiring.

In FIG. 1, the battery 10 includes a plurality of battery cells Cell1-Celln connected in series and is connected between two output terminals OUT1 and OUT2 of the battery system 1, and the relay 20 is connected between a positive electrode of the battery system 1 and the first output terminal OUT1. The components and the connection relationship between the components shown in FIG. 1 are an example, and the present disclosure is not limited thereto.

The relay 20 controls an electrical connection between the battery system 1 and an external device. When the relay 20 is turned on, the battery system 1 and the external device are electrically connected to each other to perform charging or discharging, and when the relay 20 is turned off, the battery system 1 and the external device are electrically separated from each other. In this regard, the external device may be a charger in a charge cycle in which the battery 10 is charged by supplying power to the battery 10, and may be a load in a discharge cycle in which the battery 10 discharges power to the external device.

The BMS 30 may include a plurality of slave BMSs S_BMS_1, S_BMS_2, and S_BMS_3, and a master BMS MA_BMS.

FIG. 1 shows that a plurality of battery modules B_M1, B_M2, and B_M3 constitute the battery 10, and the plurality of slave BMSs S_BMS_1, S_BMS_2, and S_BMS_3 and the master BMS MA_BMS constitute the battery management system 30, but the present disclosure is not limited thereto. For example, the battery module B_M and the slave BMS S_BMS may constitute one battery module assembly. In this regard, when the battery module B_M needs to be replaced due to aging, etc., only the battery module B_M is not replaced, and the battery module assembly may be entirely replaced. Also, FIG. 1 shows the three slave BMSs S_BMS_1, S_BMS_2, and S_BMS_3, but the present disclosure is not limited thereto. The BMS 30 may include various numbers of slave BMSs.

Hereinafter, when indicating a specific slave BMS among the plurality of slave BMSs S_BMS_1, S_BMS_2, and S_BMS_3, reference numeral "k" is used, and a communication unit, a storage unit, and a control unit included in a corresponding slave BMS S_BMS_k respectively use reference numerals "S_k_1, S_k_2, and S_k_3". Also, when indicating a battery module electrically connected to the specific slave BMS S_BMS_k, reference numeral "B_Mk" is used, and battery data collected by the specific slave BMS S_BMS_k and an ID of the slave BMS S_BMS_k respectively use reference numerals "W_data_k" and "ID_k".

The slave BMS S_BMS_k may monitor the battery module B_Mk and collect battery data including information about a state of the battery module B_Mk. According to an embodiment, the battery data may include information such as a cell voltage, a cell current, a cell temperature, etc. of each of a plurality of battery cells. According to another embodiment, the battery data may further include warranty data that is a reference for warranty period, which is a period in which maintenance and repair of the battery module B_Mk is warranted.

For example, the battery module B_Mk may be set by a manufacturer to allow free repair, etc. until 4000 charge/discharge cycles or 200 MWh of cumulative discharge energy is reached. In this regard, the charge/discharge cycles and the cumulative discharge energy may correspond to the warranty data.

Referring to FIG. 2, the slave BMS S_BMS_k may include a communication unit S_k_1, a storage unit S_k_2, and a control unit S_k_1.

The communication unit S_k_1 may communicate with the master BMS MA_BMS by using a CAN communication method to transmit battery data or receive various signals. For example, the communication unit S_k_1 may transmit the battery data stored in the storage unit S_k_2 and identification data including the identification information ID_k of the slave BMS S_BMS_k to the master BMS MA_BMS under the control of the control unit S_k_1. For another example, the communication unit S_k_1 may receive a request signal of the battery data or a request signal of the identification information ID_k from the master BMS MA_BMS.

The storage unit S_k_2 may store the battery data collected by the control unit S_k_1 every predetermined period. The storage unit S_k_2 may store the identification data including the identification information ID_k of the slave BMS S_BMS_k. For example, the identification data may be generated when the battery module assembly is manufactured and be stored in the storage unit S_k_2.

The control unit S_k_1 may monitor the slave BMS S_BMS_k, collect the battery data, and store the battery data in the storage unit S_k_2. According to an embodiment, the control unit S_k_1 may transmit the battery data and/or the identification information ID_k stored in the storage unit S_k_2 to the master BMS MA_BMS through the communication unit S_k_1, according to a request of the master BMS MA_BMS.

The master BMS MA_BMS may generally control the plurality of slave BMSs S_BMS_1, S_BMS_2, and S_BMS_3. According to an embodiment, the master BMS MA_BMS may store the battery data collected by each of the plurality of slave BMSs S_BMS_1, S_BMS_2, and S_BMS_3, and transmit the stored battery data to an external system when the external system (e.g., a vehicle system, etc.) requests the battery data. That is, the battery data may be stored not only in the plurality of slave BMSs S_BMS_1, S_BMS_2, and S_BMS_3, but also in the master BMS MA_BMS. In this regard, the external system may include a vehicle system in which the battery system 1 is mounted, an energy storage system (ESS), etc.

Referring to FIG. 3, the master BMS MA_BMS may include a master communication unit MA_1, a master storage unit MA_2, and a master control unit MA_3.

The master communication unit MA_1 may communicate with the plurality of slave BMSs S_BMS_1, S_BMS_2, and S_BMS_3 and the external system. For example, the master communication unit MA_1 may receive a request signal of the battery data transmitted from the external system. For another example, the master communication unit MA_1 may receive the battery data and/or a plurality of identification data including the identification information ID_k of each of the plurality of slave BMSs S_BMS_1, S_BMS_2, and S_BMS_3 from each of the plurality of slave BMSs S_BMS_1, S_BMS_2, and S_BMS_3.

The master storage unit MA_2 may store the battery data and the plurality of identification data including the identification information ID_k of each of the plurality of slave BMSs S_BMS_1, S_BMS_2, and S_BMS_3 transmitted from each of the plurality of slave BMSs S_BMS_1, S_BMS_2, and S_BMS_3. According to an embodiment, the master storage unit MA_2 may map and store the battery data and the identification data corresponding to each of the plurality of slave BMSs S_BMS_1, S_BMS_2, and S_BMS_3.

The master control unit MA_3 may integrate and manage the battery data collected from each of the plurality of slave BMSs S_BMS_1, S_BMS_2, and S_BMS_3. According to an embodiment, the master control unit MA_3 may manage a state of the battery data stored in each of the plurality of slave BMSs S_BMS_1, S_BMS_2, and S_BMS_3 and states of the plurality of battery data stored in the master storage unit MA_2 to be the same.

For example, referring to FIG. 4, the first slave BMS S_BMS_1 may store first battery data W_data_1, the second slave BMS S_BMS_2 may store second battery data W_data_2, and the third slave BMS S_BMS_3 may store third battery data W_data_3. According to an embodiment, the first battery data W_data_1 and first identification data including first identification information ID_1 may be mapped and stored in the master BMS MA_BMS. The second battery data W_data_2 and second identification data including second identification information ID_2 may be mapped and stored in the master BMS MA_BMS. The third battery data W_data_3 and third identification data including third identification information ID_3 may be mapped and stored in the master BMS MA_BMS. In this regard, the identification information of the first slave BMS S_BMS_1, the second slave BMS S_BMS_2, and the third slave BMS S_BMS_3, are respectively the first identification information ID_1, the second identification information ID_2, and the third identification information ID_3.

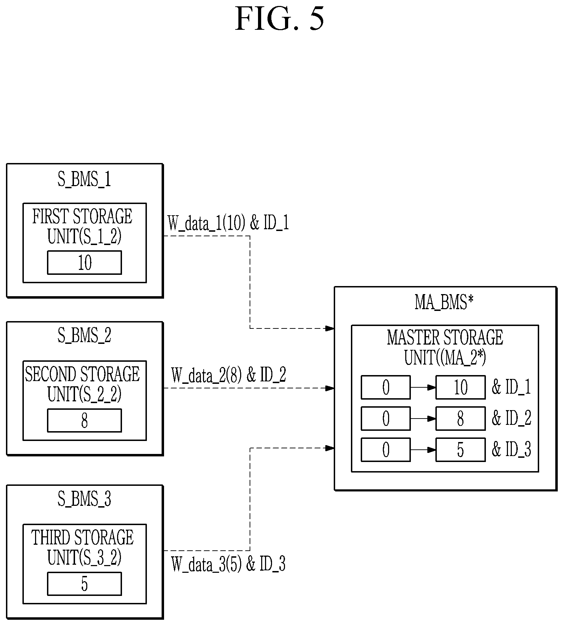

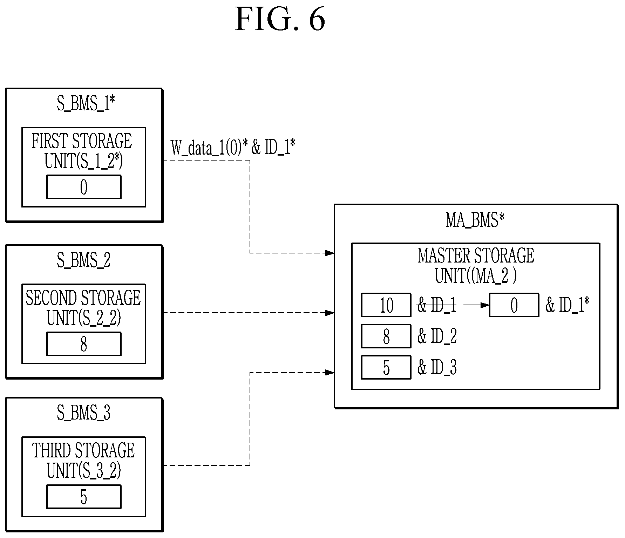

Hereinafter, a method, performed by the master control unit MA_3, of managing battery data is described in detail with reference to FIGS. 5 and 6.

FIG. 5 is a conceptual view illustrating a method of updating battery data when a master BMS is replaced according to an embodiment. FIG. 6 is a conceptual view for explaining a method of updating battery data when a first slave BMS is replaced according to an embodiment.

Referring to FIGS. 1 and 5, for example, it is assumed that the master BMS MA_BMS is replaced with a new master BMS MA_BMS* due to a failure and a functional degradation of the master BMS MA_BMS. In this regard, the new master BMS MA_BMS* may not store identification data of each of the plurality of slave BMSs S_BMS_1, S_BMS_2, and S_BMS_3. Also, battery data stored in each of the plurality of slave BMSs S_BMS_1, S_BMS_2, and S_BMS_3 may be set to an initial value (0) in the new master BMS MA_BMS*.

The new master BMS MA_BMS* may request battery data and identification data from each of the plurality of slave BMSs S_BMS_1, S_BMS_2, and S_BMS_3. The new master BMS MA_BMS* may map the battery data and the identification data received from each of the plurality of slave BMSs S_BMS_1, S_BMS_2, and S_BMS_3, and store the battery data and identification data in a master storage unit MA_2*.

Specifically, the new master BMS MA_BMS* may request and receive the first battery data W_data_1 and the first identification data ID_1 from the first slave BMS S_BMS_1, map the first battery data W_data_1 and the first identification data ID_1, and store the first battery data W_data_1 and first identification data ID_1 in the master storage unit MA_2*. In addition, the new master BMS MA_BMS* may request and receive the second battery data W_data_2 and the second identification data ID_2 from the second slave BMS S_BMS_1, map the second battery data W_data_2 and the second identification data ID_2, and store the second battery data W_data_2 and second identification data ID_2 in the master storage unit MA_2*. The new master BMS MA_BMS* may request and receive the third battery data W_data_3 and the third identification data ID_3 from the third slave BMS S_BMS_3, map the third battery data W_data_3 and the third identification data ID_3, and store the third battery data W_data_3 and third identification data ID_3 in the master storage unit MA_2*. For example, referring to FIG. 5, the first battery data W_data_1, the second battery data W_data_2, and the third battery data W_data_3 may be respectively assumed to be 10, 8, and 5.

The master storage unit MA_2* may be updated with a plurality of battery data in which the initial value 0 is mapped to each of the plurality of identification information ID_1, ID_2, and ID_3. Then, the plurality of battery data reflecting the current state of each of the plurality of slave BMSs S_BMS_1, S_BMS_2, and S_BMS_3 may be stored in the new master BMS MA_BMS* without cumbersome tasks such as connecting a PC communication cable or executing a program for data transfer.

Referring to FIGS. 1 and 6, for example, when the first battery module B_M1 is replaced due to a failure or a functional degradation thereof, it is assumed that the first slave BMS S_BMS_1 electrically connected to the first battery module B_M1 is also replaced along with the first battery module B_M1. Also, it is assumed that the first battery data W_data_1 before replacement is 10 and new first battery data W_data_1* is 0. That is, since the new first battery module B_M1* has no operating history, battery data stored in the new first slave BMS S_BMS_1* may be set to the initial value (0).

The master BMS MA_BMS may respectively update the first battery data W_data_1 and the identification data ID_1 of the first slave BMS S_BMS_1 before replacement to the new first battery data W_data_1* and new first identification data ID_1* of a new first slave BMS S_BMS_1*.

Specifically, the master BMS MA_BMS requests and receives the new first battery data W_data_1* and the new first identification data ID_1* from the new first slave BMS S_BMS_1*. The master BMS MA_BMS may map the new first battery data W_data_1* and the new first identification data ID_1* and store the new first battery data W_data_1* and new first identification data ID_1* in the master storage unit MA_2.

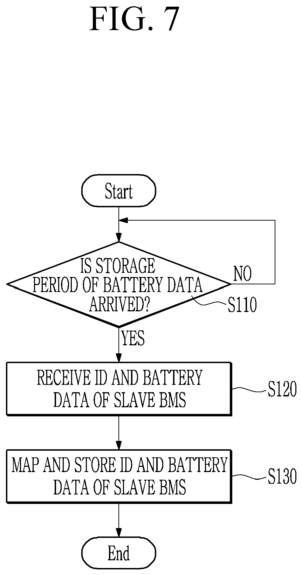

FIG. 7 is a flowchart illustrating a method of storing battery data collected by a slave BMS in a master BMS according to another embodiment.

Referring to FIG. 7, first, the master BMS MA_BMS determines whether a storage period of the battery data set according to a predetermined criterion arrives (S110).

The storage period may correspond to a period in which the slave BMS S_BMS_k collects the battery data including state information of the battery module B_Mk. For example, the storage period may correspond to a time when charge and discharge cycles of the battery 10 end. However, the present disclosure is not limited thereto, and the storage period of the master BMS MA_BMS may be set according to various criteria.

As a result of determination, when the storage period does not arrive (No of S110), the master BMS MA_BMS continues to count time.

As a result of determination, when the storage period arrives (Yes of S110), the master BMS MA_BMS requests and receives the battery data W_data_k and the identification data ID_k from each of the plurality of slave BMSs S_BMS_1, S_BMS_2, and S_BMS_3 (S120).

For each storage period, each of the plurality of slave BMSs S_BMS_1, S_BMS_2, and S_BMS_3 collects and stores the battery data. Also, according to a request of the master BMS MA_BMS, each of the plurality of slave BMSs S_BMS_1, S_BMS_2, and S_BMS_3 may transmit the collected battery data W_data_k and identification data ID_k to the master BMS MA_BMS.

According to an embodiment, the battery data may include at least one of the total number of charge and discharge cycles of the battery module B_Mk and the total energy discharged from the battery module B_Mk. For example, when the charge and discharge cycles of the battery 10 end, each of the plurality of slave BMSs S_BMS_1, S_BMS_2, and S_BMS_3 may count the cycles, and transmit the total number of cycles to the master BMS MA_BMS. For another example, when the discharge cycle of the battery 10 ends, each of the plurality of slave BMSs S_BMS_1, S_BMS_2, and S_BMS_3 may calculate the total energy discharged from the battery module B_Mk, and transmit the total energy value to the master BMS MA_BMS.

Next, the master BMS MA_BMS maps the battery data W_data_k and the identification data ID_k corresponding to each of the plurality of slave BMSs S_BMS_1, S_BMS_2, and S_BMS_3 and stores the battery data W_data_k and identification data ID_k in the master storage unit MA_2 (S130).

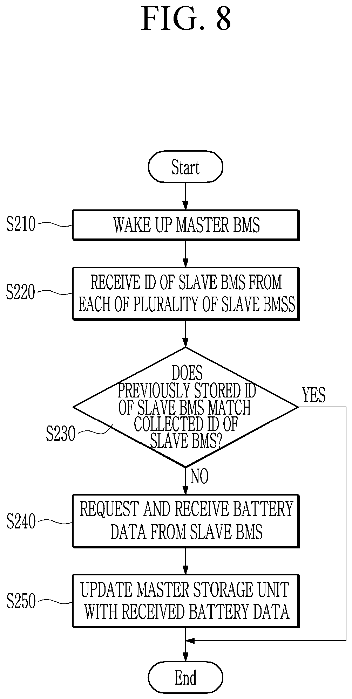

FIG. 8 is a flowchart illustrating a method of updating battery data stored in a master BMS according to another embodiment.

Referring to FIG. 8, first, when the master BMS MA_BMS receives power from a power source and wakes up, the master BMS MA_BMS requests and receives the identification data ID_k from each of the plurality of slave BMSs S_BMS_1, S_BMS_2, and S_BMS_3 (S210 and S220).

Next, the master BMS MA_BMS determines whether the identification data ID_k received from each of the plurality of slave BMSs S_BMS_1, S_BMS_2, and S_BMS_3 matches identification data previously stored in the master storage unit MA_2 (S230).

For example, when the master BMS MA_BMS or at least one slave BMS S_BMS_k among the plurality of slave BMSs S_BMS_1, S_BMS_2, and S_BMS_3 is replaced, the battery data W_data_k of the slave BMS S_BMS_k stored in the master storage unit MA_2 and the battery data W_data_k stored in the slave BMS S_BMS_k may have different states. The master BMS MA_BMS may determine whether the identification data ID_k matches whenever waking up, and check a state of the battery module B_Mk installed in the battery 10 in real time.

When a result of determination matches (YES of S230), the master BMS MA_BMS ends without a separate follow-up step.

When the result of determination does not match (NO of S230), the master BMS MA_BMS requests and receives the battery data W_data_k from the at least one slave BMS S_BMS_k of which the identification data ID_k does not match (S240).

For example, referring to FIG. 6, it is assumed that the slave BMS S_BMS_k of which the identification data ID_k does not match among the first to third slave BMSs S_BMS_1, S_BMS_2, and S_BMS_3 is the first slave BMS S_BMS_1. Then, the master BMS MA_BMS may request the new first battery data W_data_1* and the new first identification data ID_1* from the new first slave BMS S_BMS_1*.

Next, the master BMS MA_BMS updates the master storage unit MA_2 by replacing the stored battery data with the received battery data (S250).

For example, referring to FIG. 6, the master BMS MA_BMS may update the master storage unit MA_2 by deleting the first battery data W_data_1 previously stored in the master storage unit MA_2 and storing the new first battery data W_data_1* in the master storage unit MA_2. In this regard, the master BMS MA_BMS may map the new first battery data W_data_1* and the new first identification data ID_1* and store the new first battery data W_data_1* and new first identification data ID_1* in the master storage unit MA_2.

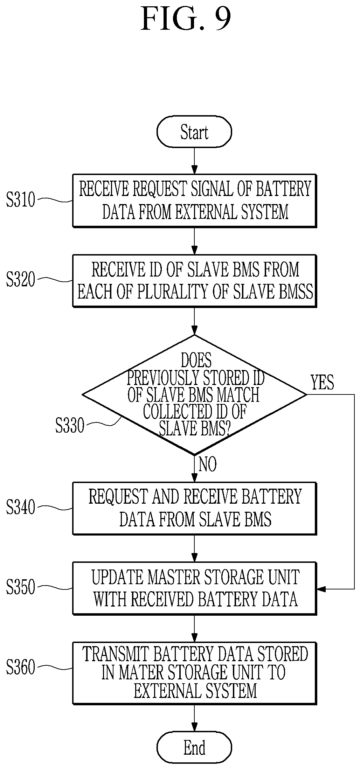

FIG. 9 is a flowchart illustrating a method, performed by a master BMS, of transmitting battery data to an external system according to another embodiment.

Referring to FIG. 9, first, the master BMS MA_BMS receives a request signal of the battery data from the external system (S310).

The external system (not shown) may be a higher system in which the battery system 1 is mounted. For example, the external system may include a system in which the battery 10 and a BMS are mounted, such as a vehicle system, an energy storage system (ESS), an electric bike, etc. The request signal of the battery data may be a signal in which the external system requests the battery data from the battery system 1.

The battery data may include information such as a cell voltage, a cell current, and a cell temperature of each of a plurality of battery cells. According to an embodiment, the battery data may further include warranty data that is a reference for warranty period, which is a period in which maintenance and repair of the battery module B_Mk is warranted.

Next, the master BMS MA_BMS requests and receives identification data from each of the plurality of slave BMSs S_BMS_1, S_BMS_2, and S_BMS_3 (S320).

The identification data may include the identification information ID_k of the slave BMS S_BMS_k. The identification information ID_k may be generated when a battery module assembly is manufactured and be stored in the storage unit S_k_2 of the slave BMS S_BMS_k. For example, the identification data of the plurality of slave BMSs S_BMS_1, S_BMS_2, and S_BMS_3 may include different identification information ID_k.

Next, the master BMS MA_BMS determines whether identification data previously stored in the master storage unit MA_2 matches the received identification data (S330).

Next, when the previously stored identification data matches the received identification data (Yes of S330), the master BMS MA_BMS transmits battery data previously stored in the master storage unit MA_2 to the external system (S360).

Next, when the previously stored identification data does not match the received identification data (No of S330), the master BMS MA_BMS requests and receives the battery data from a slave BMS corresponding to identification data that does not match (S340).

Next, the master BMS MA_BMS updates the battery data previously stored in the master storage unit MA_2 to the received battery data (S350).

Next, the master BMS MA_BMS transmits the battery data stored in the master storage unit MA_2 to the external system after an update (S360).

For each predetermined storage period, the slave BMS S_BMS_k may store collected battery data in the storage unit S_k_2 of the slave BMS S_BMS_k and transmit the battery data to the master BMS MA_BMS.

For example, for each predetermined period, the battery data collected from each of the plurality of slave BMSs S_BMS_1, S_BMS_2, and S_BMS_3 may be simultaneously stored in the plurality of slave BMSs S_BMS_1, S_BMS_2, S_BMS_3, and the master BMS MA_BMS.

For example, when the master BMS MA_BMS and at least one slave BMS S_BMS_k among the plurality of slave BMSs S_BMS_1, S_BMS_2, and S_BMS_3 is replaced, the battery data W_data_k of the slave BMS S_BMS_k stored in the master storage unit MA_2 and the battery data W_data_k stored in the slave BMS S_BMS_k may have different states. According to an embodiment, the master BMS MA_BMS may determine whether the identification data matches whenever the request signal of the battery data is received. Then, the master BMS MA_BMS may transmit the battery data including accurate information about the current state of each of the plurality of battery modules B_M1, B_M2, and B_M3 included in the battery 10 to the external system.

Although the embodiments of the present disclosure have been described in detail above, the scope of the present disclosure is not limited thereto, and various modifications and improvements made by a person of an ordinary skill in the field to which the present disclosure pertains also belong to the scope of the present disclosure.

## Claims

1. A battery management system (BMS) comprising:
a plurality of slave BMSs each configured to collect and store battery data comprising state information of a battery module for each predetermined storage period; and
a master BMS configured to receive the battery data and identification data comprising identification information of each of the plurality of slave BMSs from each of the plurality of slave BMSs for each storage period, and map and store the battery data and the identification data.

2. The BMS of claim 1, wherein:
the battery data
includes information of at least one of a total number of charge/discharge cycles of the battery module and total energy discharged from the battery module.

3. The BMS of claim 1, wherein:
the master BMS
transmits the stored battery data to an external system when receiving a request signal of the battery data from the external system.

4. The BMS of claim 3, wherein:
the master BMS
requests and receives the identification data from each of the plurality of slave BMSs when receiving a transmission request signal of the battery data, and transmits the stored battery data to the external system when the received identification data matches the stored identification data.

5. The BMS of claim 4, wherein:
the master BMS
requests and receives the battery data from a slave BMS corresponding to identification data that does not match when the received identification data does not match the stored identification data, and updates the stored battery data to the received battery data.

6. The BMS of claim 5, wherein:
the master BMS
transmits the battery data stored in the master BMS to the external system after an update.

7. The BMS of claim 1, wherein:
the master BMS
requests and receives the identification data from each of the plurality of slave BMSs when receiving power from a power source and waking up, requests and receives the battery data from at least one slave BMS in which the received identification data does not match previously stored identification data, and updates the stored battery data to the received battery data.

8. A battery data management method, performed by a master battery management system (BMS), of managing battery data collected by each of a plurality of slave BMSs electrically connected to a plurality of battery modules for each predetermined storage period and stored in each of the plurality of slave BMSs, the battery data management method comprising:
receiving a request signal of the battery data comprising state information of each of the plurality of battery modules from an external system; and
transmitting, to the external system, the battery data that is received from each of the plurality of slave BMSs for each storage period, mapped to identification data comprising identification information of each of the plurality of slave BMSs, and stored.

9. The battery data management method of claim 8, wherein:
the battery data
includes information of at least one of a total number of charge/discharge cycles of each of the plurality of battery modules and total energy discharged from each of the plurality of battery modules.

10. The battery data management method of claim 8, further comprising:
after the receiving of the request signal of the battery data,
requesting and receiving the identification data from each of the plurality of slave BMSs, and determining whether the received identification data matches identification data stored in the master BMS,
wherein the transmitting, to the external system, includes
transmitting the battery data stored in the master BMS to the external system when it is determined that the received identification data matches the identification data.

11. The battery data management method of claim 10, further comprising:
after the determining of whether the received identification data matches the previously stored identification data,
requesting and receiving the battery data from at least one slave BMS corresponding to identification data that does not match when it is determined that the received identification data does not match the identification data, and updating the stored battery data to the received battery data,
wherein the transmitting, to the external system, includes
transmitting the battery data stored in the master BMS to the external system after the updating.

12. A battery data management method, performed by a master battery management system (BMS), of managing battery data collected by each of a plurality of slave BMSs electrically connected to a plurality of battery modules for each predetermined storage period and stored in each of the plurality of slave BMSs, the battery data management method comprising:
receiving power from a power source and waking up;
requesting and receiving identification data comprising identification information of each of the plurality of slave BMSs to each of the plurality of slave BMSs;
determining whether the received identification data matches identification data stored in the master BMS;
requesting and receiving the battery data from at least one slave BMS corresponding to identification data that does not match when it is determined that the received identification data does not match the identification data; and
updating the battery data stored in the master BMS to the received battery data.

13. The battery data management method of claim 12, wherein:
the battery data
is mapped to the identification data and stored in the master BMS.

14. The battery data management method of claim 12, wherein:
the battery data
includes information of at least one of a total number of charge/discharge cycles of each of the plurality of battery modules and total energy discharged from each of the plurality of battery modules.
